(19) **Europäisches Patentamt**
**European Patent Office**
**Office européen des brevets**

(11) **EP 3 075 073 B1**

(12) **EUROPÄISCHE PATENTSCHRIFT**

(45) Veröffentlichungstag und Bekanntmachung des Hinweises auf die Patenterteilung:
**19.08.2020 Patentblatt 2020/34**

(51) Int Cl.:
***H03H 7/00*** *(2006.01)*

(21) Anmeldenummer: **14812707.9**

(22) Anmeldetag: **31.10.2014**

(86) Internationale Anmeldenummer:
**PCT/DE2014/000558**

(87) Internationale Veröffentlichungsnummer:
**WO 2015/078426 (04.06.2015 Gazette 2015/22)**

(54) **KAPAZITIV GEKOPPELTER GYRATOR AUF BASIS DES HALL-EFFEKTS**

CAPACITIVELY COUPLED HALL EFFECT GYRATOR

GYRATEUR À COUPLAGE CAPACITIF À EFFET HALL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.11.2013 DE 102013018011**

(43) Veröffentlichungstag der Anmeldung:
**05.10.2016 Patentblatt 2016/40**

(73) Patentinhaber: **Forschungszentrum Jülich GmbH 52425 Jülich (DE)**

(72) Erfinder:
• **DIVINCENZO, David**
**NL-6367 DA Voerendaal (NL)**
• **VIOLA, Giovanni**
**41279 Göteborg (DE)**

(56) Entgegenhaltungen:
DE-B- 1 144 355    US-A- 2 649 574
US-A- 3 047 821    US-A- 3 134 082
US-A- 3 214 682    US-A- 6 100 773

• KIM BRIAN S ET AL: "Generalized four-point characterization method using capacitive and ohmic contacts", REVIEW OF SCIENTIFIC INSTRUMENTS, AIP, MELVILLE, NY, US, Bd. 83, Nr. 2, 1. Februar 2012 (2012-02-01), Seiten 24703-24703, XP012161872, ISSN: 0034-6748, DOI: 10.1063/1.3677331 [gefunden am 2012-02-02]
• S. GRUTZMANN: "Hall-effect gyrators, isolators, and circulators with high efficiency", PROCEEDINGS OF THE IEEE, Bd. 51, Nr. 11, 1. November 1963 (1963-11-01), Seiten 1584-1588, XP055173930, ISSN: 0018-9219, DOI: 10.1109/PROC.1963.2630
• MICHAEL LEVIN ET AL: "Gapless layered three-dimensional fractional quantum Hall states", ARXIV.ORG, CORNELL UNIVERSITY LIBRARY, 201 OLIN LIBRARY CORNELL UNIVERSITY ITHACA, NY 14853, 5 February 2009 (2009-02-05), XP080309392, DOI: 10.1103/PHYSREVB.79.235315
• LIYUAN ZHANG ET AL: "The experimental observation of quantum Hall effect of l = 3 chiral charge carriers in trilayer graphene", ARXIV.ORG, CORNELL UNIVERSITY LIBRARY, 201 OLIN LIBRARY CORNELL UNIVERSITY ITHACA, NY 14853, 30 March 2011 (2011-03-30), XP080546966, DOI: 10.1038/NPHYS2104
• Maciej J Ogorzalek: "APPLICATIONS OF FRACTALS IN ELECTRONICS", , 20 July 2007 (2007-07-20), XP055672053, Retrieved from the Internet: URL:http://cktse.eie.polyu.edu.hk/csn2007/ Presentation%20Slides_files/MaciejOgorzale k.pdf [retrieved on 2020-02-27]

EP 3 075 073 B1

# EP 3 075 073 B1

**Beschreibung**

Die Erfindung betrifft einen Gyrator für Wechselstromsignale.

Stand der Technik

Ein Gyrator ist ein elektrisches Zweitorbauelement, bei dem die Spannung am Ausgang proportional zum Strom am Eingang ist, wobei das Vorzeichen der Spannung wechselt, wenn Eingang und Ausgang vertauscht werden. Ist der Strom ein Wechselstrom, wird er somit entweder in eine gleichphasige oder in eine gegenphasige Wechselspannung umgewandelt, je nachdem an welchem Tor des Gyrators dieser Strom vorgelegt wird. Als fünftes lineares Element neben Widerstand, Kapazität, Induktivität und idealem Transformator ist er notwendig, um Zweitorbauelemente, die eine Wechselspannung nur in einer Richtung durchlassen (Isolatoren), oder Drei- oder Mehrtorbauelemente, die eine Wechselspannung an einem Tor nur zu einem in einer festen Rotationsrichtung nächsten Tor durchlassen (Zirkulatoren), zu realisieren.

Um die Umwandlung des Eingangsstroms in die Ausgangsspannung von der Stromrichtung durch den Gyrator abhängig zu machen, wird im Mikrowellenbereich die Faraday-Rotation in Ferriten unter dem Einfluss eines externen Magnetfelds verwendet. Dazu ist es notwendig, dass sich eine durch den Eingangsstrom erzeugte elektromagnetische Welle in dem Ferriten ausbreitet. Der Ferrit muss daher Abmessungen von der Größenordnung der Wellenlänge haben und wird daher für Frequenzen im Radio- oder Tonfrequenzbereich unpraktikabel groß. Er arbeitet bei Frequenzen unterhalb des Mikrowellenbereichs auch nicht mehr effizient. Zudem ist jeder Gyrator durch seine physikalischen Abmessungen auf ein mehr oder weniger schmales Frequenzband festgelegt.

Alternativ lässt sich ein Gyrator auch als aktive Schaltung aus Transistoren und rückgekoppelten Operationsverstärkern realisieren. Eine solche Schaltung benötigt jedoch eine Energieversorgung und produziert sowohl Rauschen als auch Wärme.

Aus der US-Patentschrift 2,649,574 ist ein passiver Gyrator für tiefere Frequenzen bekannt, bei dem die Faraday-Rotation im Ferrit durch den planaren Hall-Effekt ersetzt wird. Nachteilig werden sowohl die Einkopplung des Stroms in das Hall-Effekt-Material als auch das Abgreifen der Hall-Spannung durch hohe Kontaktwiderstände behindert, was die Effizienz des Gyrators beeinträchtigt.

In der deutschen Patentanmeldung 10 2013 006 377.9 wird daher der Ansatz verfolgt, das Hall-Effekt-Material induktiv mit der Außenwelt zu koppeln, um den Hall-Effekt zu nutzen und gleichzeitig die Verluste durch Kontaktwiderstände zu vermeiden. Die Herstellung ist jedoch wegen der komplexen, nicht ebenen Geometrie aufwändig, und die induktive Ankopplung erfordert für tiefe Betriebsfrequenzen hochpermeable magnetische Materialien.

Die Schrift DE 11 44 355 B offenbart einen Gyrator für Wechselstromsignale mit einem Hall-Effekt-Material, Mittel zur Durchsetzung dieses Hall-Effekt-Materials mit einem zu seiner Ebene oder Oberfläche senkrechten Magnetfeld, mindestens einem Eingangstor sowie mindestens einem Ausgangstor zur Auskopplung einer Ausgangsspannung, die ein Maß für die durch den eingekoppelten Wechselstrom erzeugte Hall-Spannung ist, wobei jedes Tor mindestens zwei Anschlüsse aufweist, die mit der Außenwelt verbunden sind.

Die Veröffentlichung von Kim Brian S. et al "Generalized four-point characterization method using capacitive and ohmic contacts" in Review of Scientific Instruments, AIP, Melville, NY, US, Bd. 83, Nr. 2, 1. Februar 2012 (2012-02-01), Seiten 24703 - 24703, offenbart eine induktive Kopplung des Hall-Effekt-Materials mit der Außenwelt.

Die Schrift US 3,214,682 A1 offenbart einen Gyrator für Wechselstromsignale, umfassend ein Hall-Effekt-Material.

Das Dokument "APPLICATIONS OF FRACTALS IN ELECTRONICS", von Maciej J Ogorzalek, veröffentlicht 20. Juli 2007, http://cktse.eie.polyu.edu.hk/csn2007/Presentation %20Slides_files/MaciejOgorzalek.pdf, offenbart die Herstellung von Elektroden mit fraktaler Struktur, die geeignet sind, um Kondensatoren herzustellen, wobei die Kapazität pro Einheit Länge bezüglich herkommlichen Kondensatoren grösser ist.

25 Aufgabe und Lösung

Es ist daher die Aufgabe der Erfindung, einen Gyrator zur Verfügung zu stellen, der bei tiefen Frequenzen in der Größenordnung 1-100 MHz effizienter arbeitet als Gyratoren nach dem bisherigen Stand der Technik.

Diese Aufgabe wird erfindungsgemäß gelöst durch einen Gyrator gemäß Hauptanspruch. Weitere vorteilhafte Ausgestaltungen ergeben sich aus den darauf rückbezogenen Unteransprüchen.

Gegenstand der Erfindung

Im Rahmen der Erfindung wurde ein Gyrator für Wechselstromsignale entwickelt. Dieser umfasst ein Hall-Effekt-Material, Mittel zur Durchsetzung dieses Hall-Effekt-Materials mit einem zu seiner Ebene oder Oberfläche senkrechten Magnetfeld, mindestens ein Eingangstor zur Einkopplung eines Wechselstroms ($I_1$; $I_2$) in das Hall-Effekt-Material sowie mindestens ein Ausgangstor zur Auskopplung einer Ausgangsspannung ($U_2$; $U_1$), die ein Maß für die durch den eingekoppelten Wechselstrom erzeugte Hall-Spannung ist. Jedes dieser Tore weist mindestens zwei Anschlüsse auf, die mit der Außenwelt verbunden sind.

Das Hall-Effekt-Material kann beispielsweise eine Gallium-Arsenid-Heterostruktur, eine elektrisch leitfähige Monolage/Monoschicht wie beispielsweise Graphen oder ein anderes in zwei Dimensionen elektrisch leitfähiges Material sein. Seine Form in den beiden Dimensionen, in denen es leitfähig ist, kann insbesondere rund oder nahezu rund sein. Sie unterliegt prinzipiell aber keinen Einschränkungen. Es sollte sich idealerweise um einen topologischen Körper in dem Sinne handeln, dass auf ihm in einer Raumdimension eine definierte Stromrichtung für den Eingangsstrom existiert und in einer anderen, hierzu idealerweise senkrechten Raumdimension eine durch den Hall-Effekt bewirkte Ladungstrennung stattfinden kann.

Erfindungsgemäß ist mindestens ein Anschluss eines jeden Tors mit einer Anschlusselektrode verbunden, die elektrisch vom Hall-Effekt-Material isoliert ist und mit dem Hall-Effekt-Material einen Kondensator bildet. Der Wechselstrom wird also kapazitiv in das Hall-Effekt-Material eingekoppelt, und die Ausgangsspannung wird kapazitiv aus dem Hall-Effekt-Material ausgekoppelt. Der Kondensator hat vorteilhaft eine Kapazität von mindestens 300 aF, bevorzugt eine Kapazität von mindestens 1 fF.

Sofern nur ein Anschluss eines Tors mit einer Anschlusselektrode verbunden ist, kann der andere Anschluss zur Festlegung eines Bezugspunktes für den Eingangsstrom bzw. für die Ausgangsspannung beispielsweise außerhalb des Hall-Effekt-Materials mit einem definierten Potential verbunden sein. Sofern von zwei oder mehr Toren jeweils nur ein Anschluss mit einer Anschlusselektrode verbunden ist, können insbesondere alle Anschlüsse, die nicht mit einer Anschlusselektrode verbunden sind, außerhalb des Hall-Effekt-Materials mit dem gleichen definierten Potential verbunden sein. Sie können dann optional auch miteinander verbunden sein.

Die Isolierung zwischen den Anschlusselektroden und dem Hall-Effekt-Material kann beispielsweise Vakuum, ein Luftspalt oder eine auf dem Hall-Effekt-Material aufgebrachte oder um das Hall-Effekt-Material herum angebrachte Isolierschicht sein. Das Hall-Effekt-Material kann auch komplett in einem isolierenden Material vergossen sein.

Die Anschlusselektroden können aus Metall, dotierten Halbleitern oder anderen leitfähigen Materialien ohne großen Hall-Effekt bestehen. Die Verbindungen zwischen den Anschlüssen und den Anschlusselektroden sowie zwischen den Anschlüssen und der Außenwelt können durch herkömmliche Drähte realisiert sein.

Es wurde erkannt, dass bei der galvanischen Kopplung des Hall-Effekt-Materials mit den Ein- und Ausgangstoren gemäß Stand der Technik der direkte Kontakt von Anschlusselektroden mit dem Hall-Effekt-Material Randbedingungen vorgab, die eine für die Effizienz unvorteilhafte lokale Potentialverteilung innerhalb des Hall-Effekt-Materials erzwangen. Eine elektrisch leitfähige Anschlusselektrode zwang das lokale Potential in dem gesamten Bereich, in dem sie unmittelbar am Hall-Effekt-Material anlag, auf einen gemeinsamen Wert. Dieser Zwang endete am Rand der Anschlusselektrode abrupt. In diesen Randbereichen machte das Potential im Hall-Effekt-Material unstetige Sprünge. Selbst wenn das Hall-Effekt-Material als solches perfekt war und einen Hall-Winkel von annähernd 90 Grad hatte, wurde im Bereich dieser Sprünge lokal Energie dissipiert.

Indem erfindungsgemäß die Anschlusselektrode und das Hall-Effekt-Material als Platten eines Kondensators fungieren, influenziert eine auf einer dieser beiden Platten vorhandene Ladung eine entsprechende Polarisationsladung auf der anderen Platte. Dies geschieht nach den allgemeinen Regeln der Elektrostatik, wonach der Einfluss einer auf einer Platte vorhandenen Ladung auf die andere Platte über stetige Funktionen vom Abstand zu dieser Ladung abhängt. Daher sind die Randbedingungen, die die Anschlusselektrode für die Potentialverteilung im Hall-Effekt-Material vorgibt, nicht von vornherein unstetig. Das Auftreten von "hot spots", an denen Energie dissipiert wird, im Bereich von Potentialsprüngen kann somit vorteilhaft vermindert oder gar komplett unterbunden werden.

Dies gilt insbesondere in einer besonders vorteilhaften Ausgestaltung der Erfindung, in der der Kondensator Randbedingungen für die räumliche Verteilung des Potentials im Hall-Effekt-Material vorgibt, die einen stetigen Potentialverlauf in dem Bereich des Hall-Effekt-Materials zulassen, der dem Rand der Anschlusselektrode unmittelbar gegenüberliegt.

Auch wenn nur einer der beiden Anschlüsse des Eingangstors mit einer Anschlusselektrode (Eingangselektrode) verbunden ist, die mit dem Hall-Effekt-Material einen Kondensator bildet, kann bereits ein am Eingangstor vorgelegter Wechselstrom in das auf nicht definiertem ("floating") Potential liegende Hall-Effekt-Material eingekoppelt werden. Dieser Wechselstrom lädt und entlädt periodisch den aus der Eingangselektrode und dem Hall-Effekt-Material gebildeten Kondensator. In dem Hall-Effekt-Material entsteht durch den Strom eine elektromotorische Kraft, die zu einer Ladungstrennung und damit zur Ausbildung einer Hall-Spannung senkrecht zur Stromrichtung und zum Magnetfeld führt. Diese Ladungsverschiebung wirkt sich auch auf den Bereich aus, der der zum Ausgangstor gehörenden Anschlusselektrode (Ausgangselektrode) gegenüberliegt. Auf dieser Ausgangselektrode wird eine entsprechende Polarisationsladung influenziert, so dass ihr Potential geändert wird. Dies kann am Ausgangstor als Ausgangsspannung gemessen werden, die zum Eingangsstrom gleichphasig ist. Hierfür genügt bereits eine Ausgangselektrode, wenn der andere Anschluss des Ausgangstors mit einem geeigneten Bezugspunkt außerhalb des Hall-Effekt-Materials verbunden ist. Werden Eingangstor und Ausgangstor vertauscht, kehrt sich das Vorzeichen der Ausgangsspannung um, so dass sie gegenphasig zum Eingangsstrom wird.

Vorteilhaft sind beide Anschlüsse des Eingangstors mit je einer Anschlusselektrode (Eingangselektrode) verbunden, wobei beide Eingangselektroden elektrisch vom Hall-Effekt-Material isoliert sind und mit dem Hall-Effekt-Material jeweils einen Kondensator bilden. Dann kann der Wechselstrom zwischen den beiden Eingangselektroden durch das Hall-Effekt-Material getrieben werden. Dadurch erhält der Strom eine definierte Richtung durch das Hall-Effekt-Material, die wiederum die Richtung festlegt, in der die Ladungstrennung stattfindet.

Vorteilhaft sind beide Anschlüsse des Ausgangstors mit je einer Anschlusselektrode (Ausgangselektrode) verbunden, wobei beide Ausgangselektroden elektrisch vom Hall-Effekt-Material isoliert sind und mit dem Hall-Effekt-Material jeweils einen Kondensator bilden. Dann entspricht die Ausgangsspannung zwischen beiden Anschlüssen des Ausgangstors der Spannung im Hall-Effekt-Material, die zwischen den beiden Ausgangselektroden abfällt. Diese Ausgangsspannung ist frei von einem externen Bezugspunkt und somit aussagekräftiger.

Beide Maßnahmen können insbesondere in einer besonders vorteilhaften Ausführungsform der Erfindung miteinander kombiniert werden. Es bilden dann insgesamt vier Anschlusselektroden jeweils einen Kondensator mit dem Hall-Effekt-Material. Zwei der Anschlusselektroden sind dann Eingangselektroden, zwei sind Ausgangselektroden.

Prinzipiell sind beliebige Zahlen von Toren möglich, insbesondere 3, 5 oder 6. Ein Gyrator mit drei Toren lässt sich beispielsweise aus dem vorgenannten Ausführungsbeispiel mit vier Anschlusselektroden herstellen, indem ein Eingangsanschluss und ein Ausgangsanschluss leitend miteinander verbunden und als ein Anschluss des dritten Tors aufgefasst werden. Dieser kann optional auch geerdet sein. Die Funktionsweise eines Gyrators mit drei Toren wird unter der Voraussetzung, dass es sich um ein verlustfreies "ideales" Bauelement handelt, in (J. Shekel, Proceedings of the IRE 41 (8), 1014 (1953)) beschrieben. Der erfindungsgemäße Gyrator kann diese ideale Charakteristik aufweisen, wenn der Hall-Winkel θ des Hall-Effekt-Materials annähernd 90° beträgt.

Ein Gyrator mit 3, 5 oder 6 Toren kann auch beispielsweise als Zirkulator eingesetzt werden. Die Tore lassen sich dann in einer zyklischen Reihenfolge anordnen dergestalt, dass ein an einem Tor vorgelegter Eingangsstrom am nächsten Tor in der Reihe als gleichphasige Ausgangsspannung, am vorherigen Tor in der Reihe dagegen als gegenphasige Ausgangsspannung abgreifbar ist.

In einer besonders vorteilhaften Ausgestaltung der Erfindung hat das Hall-Effekt-Material in mindestens zwei Raumdimensionen eine derartige Ausdehnung, dass es entlang jeder dieser Raumdimensionen mindestens eine Million in beiden Raumdimensionen mobile Elektronen enthält. Ist diese kritische Grenze erreicht, stellen sich der Hall-Effekt und damit die Wirkung des Gyrators fast schon in voller Stärke ein. Werden die Abmessungen des Materials weiter vergrößert, ist nur noch eine vergleichsweise geringfügige Steigerung erzielbar. Kleine Strukturen sind technisch schwieriger zu fertigen als massive Körper, etwa Scheiben, aus dem Hall-Effekt-Material. Dafür wird zu ihrer Herstellung weniger von dem kostbaren Hall-Effekt-Material benötigt.

Beispielsweise kann das Hall-Effekt-Material vorteilhaft in mindestens zwei Raumdimensionen eine Ausdehnung von mindestens 100 nm, bevorzugt mindestens 500 nm und ganz besonders bevorzugt mindestens 1 μm haben. Gerade Strukturen mit einer Größe von mindestens 1 μm bieten einen besonders guten Kompromiss zwischen Materialersparnis und Komplexität der Herstellung, da sie mit technisch wenig anspruchsvoller beugungsbegrenzter Lithographie gefertigt werden können.

In einer besonders vorteilhaften Ausgestaltung der Erfindung ist die entlang eines Außenumfangs des Hall-Effekt-Materials, der von einer mit dem Eingangstor verbundenen Anschlusselektrode (Eingangselektrode) zu einer mit dem Ausgangstor verbundenen Anschlusselektrode (Ausgangselektrode) führt, gemessene lokale Kapazität pro Einheit Länge in den Randbereichen der Anschlusselektroden geringer als in den übrigen Bereichen der Anschlusselektroden. Zwischen der Leitfähigkeit σ des Hall-Effekt-Materials, dem Einheitsvektor $\vec{n}_\theta$ der gegenüber der Normalen auf die Oberfläche des Hall-Effekt-Materials um den Hall-Winkel θ verkippt ist, der Betriebsfrequenz ω, der Kapazität pro Einheit Länge c(s), dem Potential V(s) im Hall-Effekt-Material und dem durch die Anschlusselektrode bewirkten externen Potential $V_{ext}(s)$ besteht in der Nähe der Anschlusselektrode die vom Ort s auf dem Außenumfang abhängige Randbedingung

$$-\sigma \cdot \left(\vec{n}_\theta \cdot \vec{\nabla} V(s)\right) = i\omega c(s)\left(V_{ext}(s) - V(s)\right).$$

Für welchen Bereich von Frequenzen ω diese Randbedingung erfüllbar ist, hängt somit vom Verlauf von c(s) ab. Das zu einem Bereich von gewünschten Betriebsfrequenzen ω des Gyrators am besten passende c(s) kann beispielsweise durch Parameteroptimierung oder Variationsrechnung ermittelt werden.

Wenn c(s) hinreichend gutartig ist, selbst wenn es isolierte endliche Sprünge aufweist (etwa wenn die Kapazität abschnittsweise konstant ist), ist der Grenzfall θ=90° von besonderem Interesse. $\vec{n}_\theta$ verläuft dann tangential zum Außenumfang des Hall-Effekt-Materials, so dass sich die Randbedingung zu

$$- \sigma \partial V(s) = i\omega\, c(s)(V_{ext}(s) - V(s))$$

vereinfacht. Diese Gleichung stellt genau genommen nicht nur eine Randbedingung auf, sondern ist gleichzeitig auch eine geschlossene, gewöhnliche Differentialgleichung einer skalaren Variablen s, die die eindimensionale Koordinate entlang des Umfangs des Hall-Effekt-Materials beschreibt. Die Lösung für das Potential $V(\vec{r})$ im Inneren des Hall-Effekt-Materials ist im Wesentlichen durch die Lösung V(s) auf dem Rand vorgegeben.

Im homogenen Fall, in dem das äußere Potential $V_{ext}$ verschwindet, entspricht die Differentialgleichung der zeitunabhängigen Dirac-Gleichung in einer Dimension mit einer ortsabhängigen Masse, die proportional zu c(s) ist. Es ist eine Eigenwertgleichung mit der periodischen Randbedingung, dass die Lösung entlang des Umfangs des Hall-Effekt-Materials stetig ist. Es muss also V(0)=V(P) gelten, worin P die Länge des Umfangs ist. Die Lösungen hängen nicht von der Form des Umfangs ab, sondern nur von seiner Länge.

Man muss nun nur noch eine spezielle Lösung des inhomogenen Falls mit von Null verschiedenem äußerem Potential $V_{ext}$ kennen. Alle weiteren Lösungen des inhomogenen Falls ergeben sich hieraus, indem zu der speziellen Lösung eine beliebige Lösung des homogenen Falls addiert wird. Insbesondere bestimmen also die Lösungen des homogenen Falls das qualitative Verhalten des inhomogenen Falls. Eigenfrequenzen des homogenen Falls führen im inhomogenen Fall zu Polstellen, in denen die Potentialverteilung unstetig wird und "hot spots" entstehen, in denen Energie dissipiert wird. Sie entsprechen den Frequenzen, bei denen das kapazitiv angekoppelte Hall-Effekt-Material Magnetoplasmon-Resonanzen zeigt, und sind äquidistant über das Frequenzspektrum verteilt.

Es gibt also für eine gegebene Geometrie des Hall-Effekt-Materials nicht einen optimalen Bereich an Betriebsfrequenzen ω für den Gyrator, sondern es gibt im Gegenteil im Frequenzspektrum einen "Lattenzaun" äquidistant verteilter Eigenfrequenzen, bei denen das Hall-Effekt-Material eine Magnetoplasmon-Resonanz aufweist und der Gyrator daher nicht optimal arbeitet.

Abseits dieser Eigenfrequenzen, d.h. in einem Abstand von den Eigenfrequenzen, der mindestens 20 % des Abstandes zwischen zwei Eigenfrequenzen beträgt, sind die Lösungen der Differentialgleichung sehr gutartig in dem Sinne, dass keine Unstetigkeiten und daher auch keine Energie dissipierenden "hot spots" im Hall-Effekt-Material auftreten. Im Grenzfall, dass das Hall-Effekt-Material ein Quanten-Hall-Effekt-Material mit einem Hall-Winkel θ von 90° ist, ergibt die Berechnung der insgesamt dissipierten Jouleschen Wärme als Skalarprodukt $\vec{j}(\vec{r}) \cdot \nabla V(\vec{r})$ an jedem Ort $\vec{r}$ im Hall-Effekt-Material Null, da beide Vektoren immer senkrecht aufeinander stehen. Generell entspricht der Winkel zwischen beiden Vektoren dem Hall-Winkel θ.

Voraussetzung hierfür ist, dass c(s) beschränkt ist, d.h. dass es einen Wert gibt, den c(s) entlang eines von der Eingangselektrode zur Ausgangselektrode führenden Außenumfangs des Hall-Effekt-Materials nicht überschreitet. Eine Neumann-Randbedingung für die Lösung der Differentialgleichung führt zu strukturell ähnlichen Lösungen, jedoch muss entlang des Randes des Hall-Effekt-Materials c(s) gegen Unendlich streben. Die Lösung wird dann am Rand singulär, was einem starken Potentialgradienten $\nabla V(\vec{r})$ entspricht und zu verlustbehafteten "hot spots" führt.

Vorteilhaft ist daher entlang eines Außenumfangs des Hall-Effekt-Materials, der von einer mit dem Eingangstor verbundenen Anschlusselektrode zu einer mit dem Ausgangstor verbundenen Anschlusselektrode führt, die lokale Kapazität pro Einheit Länge des von jeder Anschlusselektrode mit dem Hall-Effekt-Material gebildeten Kondensators beschränkt.

Die Kapazität pro Länge c(s) kann beispielsweise variiert werden, indem der Überlapp der Anschlusselektrode mit dem Hall-Effekt-Material und/oder die Dicke und/oder die Dielektrizitätskonstante der Isolierung zwischen Anschlusselektrode und Hall-Effekt-Material variiert werden. Sie kann aber auch in einer weiteren besonders vorteilhaften Ausgestaltung der Erfindung zur Laufzeit des Gyrators variiert werden. In dieser Ausgestaltung sind Mittel zur Beaufschlagung des isolierenden Bereichs zwischen mindestens einer Anschlusselektrode und dem Hall-Effekt-Material mit einem elektrischen Biasfeld vorgesehen, das die räumliche Verteilung der Kapazität über den Bereich der Anschlusselektrode ändert. Der Kondensator enthält dann vorteilhaft ein Ferroelektrikum oder ein nichtlineares Dielektrikum als Isolierung zwischen der Anschlusselektrode und dem Hall-Effekt-Material.

In einer weiteren besonders vorteilhaften Ausgestaltung der Erfindung sind die Anschlusselektroden entlang eines Außenumfangs des Hall-Effekt-Materials derart zueinander angeordnet, dass in entgegengesetzten Richtungen entlang dieses Umfangs von einer Anschlusselektrode zur benachbarten Anschlusselektrode jeweils Wege zurückzulegen sind, deren Längen sich um nicht mehr als 10 % unterscheiden. Die Anschlusselektroden sind dann gleichmäßig entlang des Außenumfangs des Hall-Effekt-Materials verteilt. Liegt das Hall-Effekt-Material also beispielsweise als Kreisring oder Kreisscheibe vor, liegen bei einem Gyrator mit zwei zu einem Eingangstor gehörenden Eingangselektroden und zwei zu einem Ausgangstor gehörenden Ausgangselektroden, also insgesamt vier Anschlusselektroden, die Anschlusselektroden entlang des Kreisumfangs jeweils um 90° zueinander versetzt. Bei einem Gyrator mit drei Anschlusselektroden liegen diese jeweils um 120° zueinander versetzt. Je besser diese Symmetriebedingung erfüllt ist, desto höher ist die Effizienz des Gyrators. Die Bedingung gilt nicht nur für Kreisringe, Kreisscheiben und andere einfache Strukturen, sondern ganz allgemein auch für völlig irreguläre und unsymmetrische Formen des Hall-Effekt-Materials.

Diese Strukturen können in einer weiteren vorteilhaften Ausgestaltung der Erfindung zwecks Gewichts- und Materialersparnis Löcher aufweisen. Dabei kann die Gesamtfläche der Löcher bis zum Neunfachen der mit Hall-Effekt-Material belegten Fläche betragen.

Gemäß der Erfindung weist der Außenumfang des Hall-Effekt-Materials mindestens in einem Teilbereich, in dem eine der Anschlusselektroden mit ihm einen Kondensator bildet, eine selbstähnliche, insbesondere fraktale, Struktur auf. Je größer die Länge L, desto tiefere Betriebsfrequenzen ω sind möglich. Gerade für tiefere Frequenzen im Radio- und Audiobereich standen bislang keine effektiven Gyratoren zur Verfügung; die Erfindung soll gerade diese Lücke schließen. Eine selbstähnliche, insbesondere fraktale, Struktur ist eine der Strukturen mit der größten Länge L bei gleichzeitig minimalem Materialverbrauch, die topologisch noch als ein Körper angesehen werden kann, so dass in ihr eine definierte Stromrichtung und eine Richtung für die Ladungstrennung durch den Hall-Effekt existieren.

Ebenso ist es zur Erzielung tiefer Betriebsfrequenzen auch vorteilhaft, die Kapazität des durch Anschlusselektrode und Hall-Effekt-Material gebildeten Kondensators möglichst groß zu machen. Dazu kann beispielsweise die Anschlusselektrode einen ebenen Bereich des Hall-Effekt-Materials teilweise überlappen, und zwar entweder einseitig oder beidseitig, jeweils durch eine geeignete Isolierung beabstandet.

An Stelle einer fraktalen Struktur kann auch eine andere stark gewundene Struktur verwendet werden, etwa eine interdigitierende Struktur, wie sie für Metallelektroden von Dünnfilmkondensatoren verwendet wird.

Für den Spezialfall eines Gyrators mit zwei Eingangs- und zwei Ausgangselektroden ist die Matrix $Y_2$ des komplexen Leitwerts gegeben durch

$$Y_2(\omega) = \sigma \begin{pmatrix} iy_o(\omega) & y_e(\omega) \\ -y_e(\omega) & iy_o(\omega) \end{pmatrix},$$

worin $y_e(\omega)$ gerade und $y_0(\omega)$ ungerade Funktionen der Frequenz ω sind. σ ist die Leitfähigkeit des Hall-Materials. Notwendige Voraussetzung für diese symmetrische Form der Matrix $Y_2(\omega)$ ist, dass die durch alle Anschlusselektroden jeweils mit dem Hall-Effekt-Material gebildeten Kondensatoren gleiche Kapazitäten haben. Daher haben in einer besonders vorteilhaften Ausgestaltung der Erfindung die durch alle Anschlusselektroden jeweils mit dem Hall-Effekt-Material gebildeten Kondensatoren Kapazitäten, die sich höchstens um 10 % voneinander unterscheiden.

Sofern in den Bereichen, in denen die Anschlusselektroden mit dem Hall-Effekt-Material jeweils einen Kondensator bilden, dessen Kapazität zumindest abschnittsweise konstant ist, führt die zuvor diskutierte eindimensionale Differentialgleichung in jedem dieser Abschnitte auf Funktionen

$$y_o(\omega) = -\tan\left(\frac{c\,\omega\,W}{\sigma}\right) / 2$$

$$y_e(\omega) = \left(\sec\left(\frac{c\,\omega\,W}{\sigma}\right) - 1\right) / 2$$

worin W die Länge des Abschnitts ist, auf dem die Kapazität pro Einheit Länge c(s) konstant ist, und c der konstante Wert von c(s) in diesem Abschnitt ist.

$Y_2(\omega)$ wird zur Matrix eines idealen Gyrators, wenn $y_0(\omega)=0$ ist. Diese Nullstellen treten periodisch in der Frequenz auf und liegen jeweils genau in der Mitte zwischen zwei Magnetoplasmon-Resonanzfrequenzen. Sie sind die optimalen Betriebsfrequenzen des Gyrators. An ihnen ist $c\omega W/\sigma$ ein ungeradzahliges Vielfaches von π.

Durch den Wert von σ wird die Impedanz des Gyrators eingestellt und insbesondere an die Geräte oder Bauelemente der Außenwelt angepasst, die an den Toren angeschlossen sind. In der Regel ist man bestrebt, σ zu erhöhen, um die Impedanz in die Nähe der Standard-Impedanz für Hochfrequenzanwendungen von 50 Ω zu bringen.

Für einen Gyrator mit drei Toren, insbesondere einen Gyrator mit drei Anschlusselektroden, lautet die Matrix $Y_3(\omega)$ des komplexen Leitwerts

$$Y_3(\omega) = \sigma \begin{pmatrix} iy_d(\omega) & y_l(\omega) & -y_l^*(\omega) \\ -y_l^*(\omega) & iy_d(\omega) & y_l(\omega) \\ y_l(\omega) & -y_l^*(\omega) & iy_d(\omega) \end{pmatrix},$$

worin

$$y_d(\omega) = \frac{-2\sin\left(\dfrac{c\,\omega W}{\sigma}\right)}{1 + 2\cos\left(\dfrac{c\,\omega W}{\sigma}\right)},$$

$$y_l(\omega) = \frac{1 - \exp\left(\dfrac{c\,\omega W}{\sigma}\right)}{1 + 2\cos\left(\dfrac{c\,\omega W}{\sigma}\right)}$$

und der Stern (*) den komplex konjugierten Wert bezeichnet. Ideale gyratorische Wirkung zwischen den drei Toren stellt sich bei den Frequenzen $\omega$ ein, an denen $y_d(\omega)=0$ und zugleich $Y_l(\omega)$ reellwertig ist.

Voraussetzung für die symmetrische Form der Matrix $Y_3(\omega)$ ist, dass die drei Tore jeweils mit Anschlusselektroden verbunden sind, die in der Summe gleiche Kapazitäten mit dem Hall-Effekt-Material bilden. Dies lässt sich beispielsweise erreichen, indem jeweils ein Anschluss eines der drei Tore mit einer Anschlusselektrode verbunden ist und alle drei Anschlusselektroden gleiche Kapazitäten mit dem Hall-Effekt-Material bilden. Gleiche Kapazitäten für alle drei Tore lassen sich aber auch mit vier Anschlusselektroden realisieren, von denen zwei jeweils eine halb so große Kapazität mit dem Hall-Effekt-Material bilden wie die beiden anderen. Die beiden Anschlusselektroden mit den halb so großen Kapazitäten werden dann miteinander verbunden und dem gleichen Tor zugeordnet.

Maßgeblich für das Verhalten des Gyrators ist jeweils nur der Anteil des Außenumfangs des Hall-Effekt-Materials, der mit den Anschlusselektroden einen Kondensator bildet. In einer besonders vorteilhaften Ausgestaltung der Erfindung bildet das Hall-Effekt-Material daher entlang mindestens eines Außenumfangs auf mindestens 2 %, bevorzugt zwischen 50 % und 70 %, der Länge dieses Außenumfangs einen Kondensator mit mindestens einer Anschlusselektrode.

In einer weiteren vorteilhaften Ausgestaltung der Erfindung bildet mindestens eine Anschlusselektrode mit mehreren elektrisch voneinander isolierten Schichten des Hall-Effekt-Materials einen Kondensator. Liegt das Hall-Effekt-Material als Stapelung mehrerer solcher Schichten vor, beispielsweise in Form von Scheiben, wird der gyratorische Effekt, also der Betrag der Proportionalitätskonstante zwischen Ausgangsspannung und Eingangsstrom, vorteilhaft vergrößert und Randeffekte des Kondensators reduziert.

In einer besonders vorteilhaften Ausgestaltung der Erfindung ist das Hall-Effekt-Material ein Quanten-Hall-Effekt-Material. Der Hall-Winkel $\theta$, um den die Ladungstrennung von der Stromrichtung durch das Material verkippt ist, ist dann annähernd 90°. Dies gilt auch für einige Hall-Effekt-Materialien ohne Quanten-Hall-Effekt, wie beispielsweise Arsen, Antimon, Wismut, $\alpha$-Zinn (graues Zinn), Graphit sowie dünne Schichten dotierter Halbleiter. Für viele weitere Materialien gibt es Temperaturbereiche, in denen sie diese Eigenschaft ebenfalls aufweisen.

Bei einem Hall-Winkel von 90° führt ein stetiger Potentialverlauf im Inneren des Hall-Effekt-Materials dazu, dass keine Energie mehr an "hot spots" dissipiert wird. Ein verlustfreier Gyrator, der zugleich noch passiv ist und somit kein zusätzliches Rauschen produziert, lässt sich besonders vorteilhaft bei Tieftemperaturexperimenten einsetzen, in denen eine Dissipation zu unerwünschter Erwärmung führen würde. Die Rauschfreiheit ist insbesondere bei Experimenten mit Qubits von Vorteil. Prinzipiell profitieren aber alle Anwendungen im Radio- und Audiofrequenzbereich unterhalb von 100 MHz von der Verfügbarkeit des erfindungsgemäßen Gyrators.

Idealerweise weist das Hall-Effekt-Material einen Hall-Winkel $\theta$ auf, der so nahe wie möglich bei 90° liegt, und erfordert hierzu ein möglichst geringes Magnetfeld. Die Hall-Eigenschaften sollten unter den weiteren Verarbeitungsschritten zur Herstellung des fertigen Bauelements Gyrator nicht leiden. Es ist von Vorteil, wenn das Hall-Effekt-Material leicht strukturierbar und mechanisch bearbeitbar ist und wenn mehrere Schichten aus diesem Material leicht parallel geschaltet werden können, um die Kapazität des Kondensators zu vergrößern.

Die Herleitung der Randbedingung entlang des Außenumfangs des Hall-Effekt-Materials, mit der das Verhalten des Gyrators studiert wurde, geht davon aus, dass im Inneren des Hall-Effekt-Materials der Stromdichtevektor $\vec{j}(\vec{r})$ mindestens lokal linear proportional zum elektrischen Feld $\vec{E}(\vec{r})$ ist:

$$\vec{j}(\vec{r}) = -\sigma\, R_\theta\, \vec{E}(\vec{r})$$

$$\hat{u} \cdot \vec{j}(\vec{r}) = -\sigma \, \partial_{\left(R_\theta^{-1}\hat{u}\right)} V(\vec{r})$$

Hierin ist $\vec{r}$ der zweidimensionale Ortsvektor in der Ebene des Hall-Effekt-Materials. $\sigma$ ist die Leitfähigkeit, die in zwei Dimensionen die Einheit Ampere pro Volt hat. $R_\theta$ ist ein Operator, der einen Vektor um den Winkel $\theta$ um eine Achse dreht, die parallel zu dem Magnetfeld ist, mit dem das Hall-Effekt-Material durchsetzt ist, und senkrecht auf der Ebene steht, in der das zweidimensionale Elektronengas beweglich ist. $\hat{u}$ ist ein beliebiger Einheitsvektor in dieser Ebene. $\vec{E}(\vec{r})$ ist der Gradient des Potentialfeldes $\vec{V}(\vec{r})$ Bei den interessierenden tiefen Frequenzen reichen die Gesetze der Elektrostatik aus, um die Felder im Inneren des Hall-Effekt-Materials zu beschreiben. V genügt also der Laplace-Gleichung

$$\nabla^2 V(\vec{r}) = 0 \, .$$

Die erfindungsgemäß vorgesehenen kapazitiven Anschlusselektroden führen entlang des Außenumfangs des Hall-Effekt-Materials eine lokale Kapazität $\vec{c}(\vec{s})$ pro Einheit Länge als Funktion des Ortes $\vec{s}$ auf diesem Außenumfang ein. Im Bereich der Anschlusselektroden ist $\vec{c}(\vec{s})$ endlich; in den Lücken zwischen den Anschlusselektroden fällt $\vec{c}(\vec{s})$ auf Null ab. Zwischen der Kapazität C eines Kondensators und der auf ihm gespeicherten Ladung Q besteht allgemein der Zusammenhang

$$Q = C\Delta V = C(V_{ext} - V) \, .$$

Zeitableitung führt auf einen Ausdruck für die Stromdichte:

$$\hat{n} \cdot \vec{j}(\vec{s}) = \dot{Q}(\vec{s}) = c(\vec{s})\left(\dot{V}_{ext} - \dot{V}(\vec{s})\right) .$$

Mit dem eingangs aufgestellten Ausdruck für die Stromdichte ergibt sich unter der Annahme, dass sowohl $V_{ext}$ als auch V mit Kreisfrequenz $\omega$ sinusförmig von der Zeit abhängen, die zentrale Randbedingung, die das Verhalten des erfindungsgemäßen Gyrators beschreibt. Sein Funktionieren folgt somit bereits aus den grundlegenden Gesetzen der Elektrostatik.

Spezieller Beschreibungsteil

Nachfolgend wird der Gegenstand der Erfindung an Hand von Figuren erläutert, ohne dass der Gegenstand der Erfindung hierdurch beschränkt wird. Es ist gezeigt:

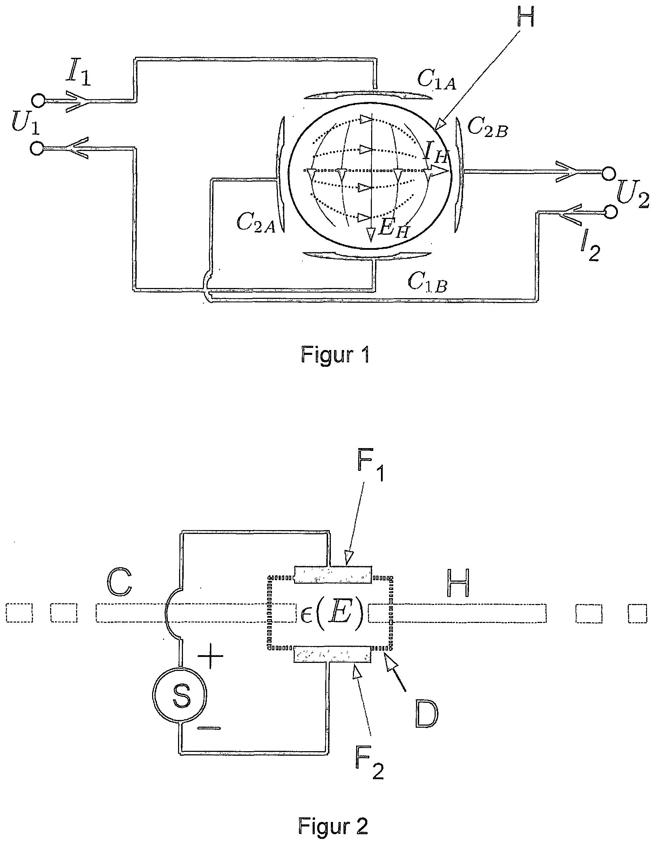

Figur 1 zeigt eine einfache Ausführungsform des erfindungsgemäßen Gyrators. Das Hall-Effekt-Material H liegt hier als Kreisscheibe vor. Entlang des Umfangs dieser Kreisscheibe sind, jeweils um 90° zueinander versetzt, vier metallische Anschlusselektroden angeordnet, die mit dem Hall-Effekt-Material H jeweils einen Kondensator bilden. Über zwei gegenüberliegende Eingangselektroden $C_{1A}$ und $C_{1B}$ wird ein Wechselstrom $I_H$ durch das Hall-Effekt-Material getrieben. Durch den Hall-Effekt in Verbindung mit einem senkrecht auf der Zeichenebene stehenden Magnetfeld wird ein elektrisches Hall-Feld $E_H$ erzeugt, das senkrecht auf der Stromrichtung steht. Dieses führt zu einer Ladungstrennung in Feldrichtung. Auf den gegenüberliegenden Ausgangselektroden $C_{2A}$ und $C_{2B}$ werden entsprechende Polarisationsladungen influenziert, so dass sich zwischen diesen beiden Ausgangselektroden eine Potentialdifferenz ausbildet. Diese kann als Ausgangsspannung $U_2$ abgegriffen werden. Die Ausgangsspannung $U_2$ ist gleichphasig zum Eingangsstrom $I_1$.

Wird ein Strom $I_2$ zwischen den Ausgangselektroden $C_{2A}$ und $C_{2B}$ durch das Hall-Effekt-Material H getrieben, entsteht in analoger Weise zwischen den Eingangselektroden $C_{1A}$ und $C_{1B}$ eine Ausgangsspannung $U_1$, jedoch mit umgekehrtem Vorzeichen. Die Ausgangsspannung $U_1$ ist also gegenphasig zum Eingangsstrom $I_2$.

Figur 2 veranschaulicht die lokale Beeinflussung der Kapazität des zwischen Anschlusselektrode C und Hall-Effekt-Material H gebildeten Kondensators zur Laufzeit des Gyrators in Seitenansicht. Die Anschlusselektrode C ist durch ein Dielektrikum D gegen das Hall-Effekt-Material H isoliert. Dieses Dielektrikum D ist ein Ferroelektrikum oder ein nichtlineares Dielektrikum, so dass seine Dielektrizitätskonstante $\varepsilon$ vom elektrischen Feld E in seinem Inneren abhängt, $\varepsilon=\varepsilon(E)$. Über eine Spannungsquelle S werden nun zwei Hilfselektroden $F_1$ und $F_2$ gespeist, zwischen denen sich ein variables elektrisches Feld aufbaut. Mit diesem Feld kann $\varepsilon$ im Inneren des Dielektrikums D auf den gewünschten Wert eingestellt werden.

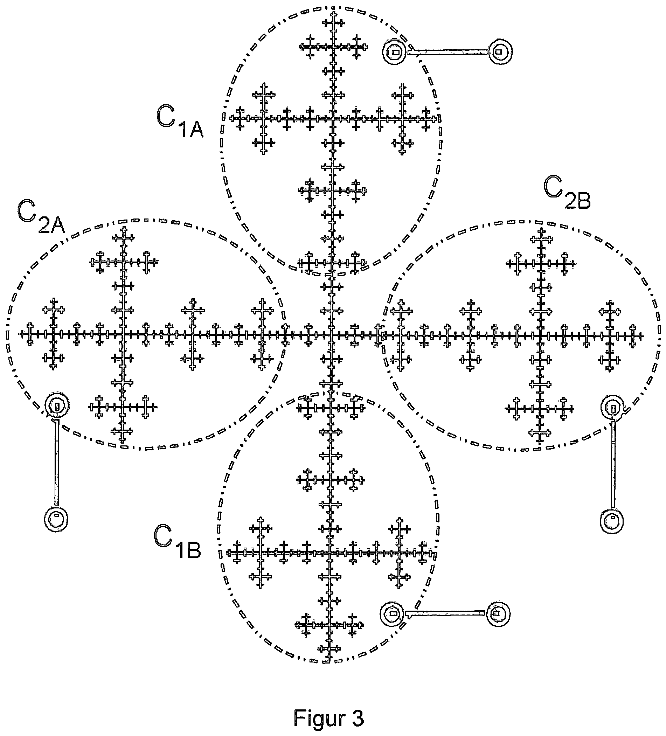

Figur 3 zeigt ein Ausführungsbeispiel eines erfindungsgemäßen Gyrators, bei dem das Hall-Effekt-Material H eine fraktale Struktur aufweist. In den mit Strichen und Punkten im Wechsel umrandeten Bereichen bildet das komplett von einem (in Figur 3 nicht eingezeichneten) Dielektrikum umgebene Hall-Effekt-Material H analog zu Figur 1 mit den vier Anschlusselektroden $C_{1A}$, $C_{1B}$, $C_{2A}$ und $C_{2B}$ jeweils einen Kondensator. Die fraktale Form verlängert den Außenumfang des Hall-Effekt-Materials H, ohne dass dieses insgesamt mehr Platz in Anspruch nimmt. Es ist eine Form mit minimalem Verbrauch an Hall-Effekt-Material pro Einheit Länge des Außenumfangs.

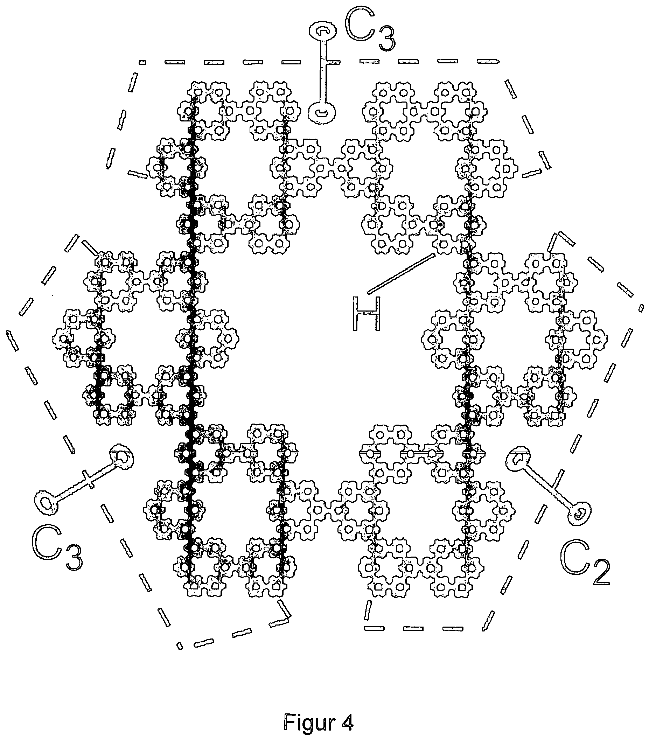

Figur 4 zeigt ein weiteres Ausführungsbeispiel eines erfindungsgemäßen Gyrators, bei dem das Hall-Effekt-Material H eine fraktale Struktur aufweist. Das Material ist aus vielen kleinen Sechsecken zusammengesetzt, wobei Übergangswiderstände zwischen diesen Sechsecken vernachlässigt werden. In den mit einer gestrichelten Linie umrandeten Bereichen bildet das Hall-Effekt-Material H mit den drei Anschlusselektroden $C_1$, $C_2$ und $C_3$ jeweils einen Kondensator. In den beiden entgegengesetzten Richtungen entlang des Außenumfangs des Hall-Effekt-Materials H sind die Wege von einer Anschlusselektrode zu den beiden anderen (benachbarten) Anschlusselektroden jeweils gleich; so ist es etwa von $C_2$ nach $C_1$ genauso weit wie von $C_2$ nach $C_3$. Die Löcher in der Struktur des Hall-Effekt-Materials H reduzieren den Materialverbrauch, das Material ist aber nach wie vor ein ganzer topologischer Körper.

**Patentansprüche**

1. Gyrator für Wechselstromsignale, umfassend ein Hall-Effekt-Material, Mittel zur Durchsetzung dieses Hall-Effekt-Materials mit einem zu seiner Ebene oder Oberfläche senkrechten Magnetfeld, mindestens ein Eingangstor zur Einkopplung eines Wechselstroms ($I_1$; $I_2$) in das Hall-Effekt-Material sowie mindestens ein Ausgangstor zur Auskopplung einer Ausgangsspannung ($U_2$; $U_1$), die ein Maß für die durch den eingekoppelten Wechselstrom erzeugte Hall-Spannung ist, wobei jedes Tor mindestens zwei Anschlüsse aufweist, die mit der Außenwelt verbunden sind, wobei, mindestens ein Anschluss eines jeden Tors mit einer Anschlusselektrode verbunden ist, die elektrisch vom Hall-Effekt-Material isoliert ist und mit dem Hall-Effekt-Material einen Kondensator bildet,
   **dadurch gekennzeichnet,**
   **dass** der Außenumfang des Hall-Effekt-Materials mindestens in einem Teilbereich, in dem eine der Anschlusselektroden mit ihm einen Kondensator bildet, eine selbstähnliche Struktur aufweist.

2. Gyrator nach Anspruch 1,
   **dadurch gekennzeichnet, dass**
   der Kondensator Randbedingungen für die räumliche Verteilung des Potentials im Hall-Effekt-Material vorgibt, die einen stetigen Potentialverlauf in dem Bereich des Hall-Effekt-Materials zulassen, der dem Rand der Anschlusselektrode unmittelbar gegenüberliegt.

3. Gyrator nach einem der Ansprüche 1 bis 2,
   **dadurch gekennzeichnet, dass**
   beide Anschlüsse des Eingangstors mit je einer Anschlusselektrode verbunden sind, wobei diese beiden Anschlusselektroden elektrisch vom Hall-Effekt-Material isoliert sind und mit dem Hall-Effekt-Material jeweils einen Kondensator bilden.

4. Gyrator nach einem der Ansprüche 1 bis 3,
   **dadurch gekennzeichnet, dass**
   beide Anschlüsse des Ausgangstors mit je einer Anschlusselektrode verbunden sind, wobei diese beiden Anschlusselektroden elektrisch vom Hall-Effekt-Material isoliert sind und mit dem Hall-Effekt-Material jeweils einen Kondensator bilden.

5. Gyrator nach einem der Ansprüche 1 bis 4,
   **dadurch gekennzeichnet, dass**
   das Hall-Effekt-Material in mindestens zwei Raumdimensionen eine derartige Ausdehnung hat, dass es entlang jeder dieser Raumdimensionen mindestens eine Million in beiden Raumdimensionen mobile Elektronen enthält.

**6.** Gyrator nach einem der Ansprüche 1 bis 5,
**dadurch gekennzeichnet, dass**
das Hall-Effekt-Material in mindestens zwei Raumdimensionen eine Ausdehnung von mindestens 100 nm, bevorzugt mindestens 500 nm und ganz besonders bevorzugt mindestens 1 μm hat.

**7.** Gyrator nach einem der Ansprüche 1 bis 6,
**dadurch gekennzeichnet, dass**
die entlang eines Außenumfangs des Hall-Effekt-Materials, der von einer mit dem Eingangstor verbundenen Anschlusselektrode zu einer mit dem Ausgangstor verbundenen Anschlusselektrode führt, gemessene lokale Kapazität pro Einheit Länge in den Randbereichen der Anschlusselektroden geringer ist als in den übrigen Bereichen der Anschlusselektroden.

**8.** Gyrator nach einem der Ansprüche 1 bis 7,
**dadurch gekennzeichnet, dass**
entlang eines Außenumfangs des Hall-Effekt-Materials, der von einer mit dem Eingangstor verbundenen Anschlusselektrode zu einer mit dem Ausgangstor verbundenen Anschlusselektrode führt, die lokale Kapazität pro Einheit Länge des von jeder Anschlusselektrode mit dem Hall-Effekt-Material gebildeten Kondensators beschränkt ist.

**9.** Gyrator nach einem der Ansprüche 1 bis 8,
**dadurch gekennzeichnet, dass**
Mittel zur Beaufschlagung des isolierenden Bereichs zwischen mindestens einer Anschlusselektrode und dem Hall-Effekt-Material mit einem elektrischen Biasfeld vorgesehen sind, das die räumliche Verteilung der Kapazität über den Bereich der Anschlusselektrode ändert.

**10.** Gyrator nach Anspruch 9,
**dadurch gekennzeichnet,**
**dass** der Kondensator ein Ferroelektrikum oder ein nichtlineares Dielektrikum als Isolierung zwischen der Anschlusselektrode und dem Hall-Effekt-Material enthält.

**11.** Gyrator nach einem der Ansprüche 1 bis 10,
**dadurch gekennzeichnet, dass**
die Anschlusselektroden entlang eines Außenumfangs des Hall-Effekt-Materials derart zueinander angeordnet sind, dass in entgegengesetzten Richtungen entlang dieses Umfangs von einer Anschlusselektrode zur benachbarten Anschlusselektrode jeweils Wege zurückzulegen sind, deren Längen sich um nicht mehr als 10 % unterscheiden.

**12.** Gyrator nach einem der Ansprüche 1 bis 11,
**dadurch gekennzeichnet, dass**
das Hall-Effekt-Material Löcher aufweist, deren Gesamtfläche bis zum Neunfachen der mit Hall-Effekt-Material belegten Fläche beträgt.

**13.** nach einem der Ansprüche 1 bis 12,
**dadurch gekennzeichnet, dass**
der Außenumfang des Hall-Effekt-Materials mindestens in einem Teilbereich, in dem eine der Anschlusselektroden mit ihm einen Kondensator bildet, eine fraktale Struktur aufweist.

**14.** Gyrator nach einem der Ansprüche 1 bis 13,
**dadurch gekennzeichnet, dass**
die durch alle Anschlusselektroden jeweils mit dem Hall-Effekt-Material gebildeten Kondensatoren Kapazitäten haben, die sich höchstens um 10 % voneinander unterscheiden.

**15.** Gyrator nach einem der Ansprüche 1 bis 14,
**dadurch gekennzeichnet, dass**
das Hall-Effekt-Material entlang mindestens eines Außenumfangs auf mindestens 2 %, bevorzugt zwischen 50 % und 70 %, der Länge dieses Außenumfangs einen Kondensator mit mindestens einer Anschlusselektrode bildet.

**16.** Gyrator nach einem der Ansprüche 1 bis 15,
**dadurch gekennzeichnet, dass**
mindestens eine Anschlusselektrode mit mehreren elektrisch voneinander isolierten Schichten des Hall-Effekt-Materials einen Kondensator bildet.

17. Gyrator nach einem der Ansprüche 1 bis 16,
**dadurch gekennzeichnet, dass**
das Hall-Effekt-Material ein Quanten-Hall-Effekt-Material ist.


**Claims**

1. A gyrator for alternating current signals, comprising a Hall effect material, means for passing through this Hall effect material with a magnetic field being perpendicular to the plane or surface thereof, at least one input gate for coupling an alternating current ($I_1$; $I_2$) into the Hall effect material and at least one output gate for coupling out an output voltage ($U_2$; $U_1$) which is a measure for the Hall voltage generated by the coupled alternating current, wherein each gate has at least two connections connected to the outside world, wherein at least one connection of each gate is connected to a connection electrode which is electrically insulated from the Hall effect material and forms a capacitor with the Hall effect material,
**characterized in that**
the outer circumference of the Hall effect material has a self-similar structure at least in a partial region in which one of the connection electrodes forms a capacitor with it.

2. The gyrator according to claim 1,
**characterized in that**
the capacitor specifies edge conditions for the spatial distribution of the potential in the Hall effect material permitting a continuous potential profile in the region of the Hall effect material being directly opposite the edge of the connection electrode.

3. The gyrator according to any of claims 1 to 2,
**characterized in that**
both connections of the input gate are each connected to a connection electrode, wherein these two connection electrodes are electrically insulated from the Hall effect material and each form a capacitor with the Hall effect material.

4. The gyrator according to any of claims 1 to 3,
**characterized in that**
both connections of the output gate are each connected to a connection electrode, wherein these two connection electrodes are electrically insulated from the Hall effect material and each form a capacitor with the Hall effect material.

5. The gyrator according to any of claims 1 to 4,
**characterized in that**
the Hall effect material has an extent in at least two spatial dimensions in such a way that it contains at least one million mobile electrons in both spatial dimensions along each of these spatial dimensions.

6. The gyrator according to any of claims 1 to 5,
**characterized in that**
the Hall effect material, in at least two spatial dimensions, has an extent of at least 100 nm, preferably at least 500 nm and very particularly preferably at least 1 $\mu$m.

7. The gyrator according to any of claims 1 to 6,
**characterized in that**
the local capacitance measured along an outer circumference of the Hall effect material, which leads from a connection electrode which is connected to the input gate to a connection electrode, which is connected to the output gate, is smaller per unit length in the edge regions of the connection electrodes than in the remaining regions of the connection electrodes.

8. The gyrator according to any of claims 1 to 7,
**characterized in that**
along an outer circumference of the Hall effect material, which leads from a connection electrode which is connected to the input gate to a connection electrode which is connected to the output gate, the local capacitance per unit length of the capacitor formed by each connection electrode with the Hall effect material is limited.

**9.** The gyrator according to any of claims 1 to 8,
**characterized in that**
means are provided for acting on the insulating region between at least one connection electrode and the Hall effect material with an electrical bias field which changes the spatial distribution of the capacitance over the region of the connection electrode.

**10.** The gyrator according to claim 9,
**characterized in that**
the capacitor contains ferroelectric or non-linear dielectric as insulation between the connection electrode and the Hall effect material.

**11.** The gyrator according to any of claims 1 to 10,
**characterized in that**
the connection electrodes are arranged with respect to one another along an outer circumference of the Hall effect material in such a way that, in opposite directions along this circumference from a connection electrode to the adjacent connection electrode, paths are each to be covered, the lengths of which differ by no more than 10%.

**12.** The gyrator according to any of claims 1 to 11,
**characterized in that**
the Hall effect material has holes, the total area of which is up to nine times the area which is occupied by Hall effect material.

**13.** The gyrator according to any of claims 1 to 12,
**characterized in that**
the outer circumference of the Hall effect material has a fractal structure at least in a sub-region in which one of the connection electrodes forms a capacitor with it.

**14.** The gyrator according to any of claims 1 to 13,
**characterized in that**
the capacitors, which are each formed with the Hall effect material by all connection electrodes, have capacitances which differ from one another by at most 10%.

**15.** The gyrator according to any of claims 1 to 14,
**characterized in that**
the Hall effect material, along at least one outer circumference to at least 2%, preferably between 50% and 70%, of the length of this outer circumference, forms a capacitor having at least one connection electrode.

**16.** The gyrator according to any of claims 1 to 15,
**characterized in that**
at least one connection electrode forms a capacitor with several layers of the Hall effect material which are electrically insulated from each other.

**17.** The gyrator according to any of claims 1 to 16,
**characterized in that**
the Hall effect material is a quantum Hall effect material.


**Revendications**

**1.** Gyrateur pour des signaux de courant alternatif, comprenant un matériau à effet Hall, des moyens pour soumettre ce matériau à effet Hall à un champ magnétique perpendiculairement à son plan ou sa surface, au moins une porte d'entrée pour injecter un courant ($I_1$ ; $I_2$) alternatif dans le matériau à effet Hall, ainsi qu'au moins une porte de sortie pour la sortie d'une tension (U2 ; U1) de sortie, qui est une mesure de la tension Hall produite par le courant alternatif injecté, chaque porte ayant au moins deux bornes, qui sont reliées au monde extérieur,
dans lequel
au moins une borne de chaque porte est reliée à une électrode de connexion, qui est isolée électriquement du matériau à effet Hall et qui forme un condensateur avec le matériau à effet Hall,
**caractérisé**

**en ce que** le pourtour extérieur du matériau à effet Hall a, au moins dans une région partielle, dans laquelle l'une des électrodes de connexion forme avec lui un condensateur, une structure semblable à elle-même.

2. Gyrateur suivant la revendication 1,
   **caractérisé en ce que**
   le condensateur prescrit des conditions aux limites de la répartition dans l'espace du potentiel dans le matériau à effet Hall, qui autorisent une courbe de potentiel constante dans la région du matériau à effet Hall, qui est directement en face du bord de l'électrode de connexion.

3. Gyrateur suivant l'une des revendications 1 à 2,
   **caractérisé en ce que**
   les deux bornes de la porte d'entrée sont reliées à, respectivement, une électrode de connexion, ces deux électrodes de connexion étant isolées électriquement du matériau à effet Hall et formant avec le matériau à effet Hall, respectivement, un condensateur.

4. Gyrateur suivant l'une des revendications 1 à 3,
   **caractérisé en ce que**
   les deux bornes de la porte de sortie sont reliées, respectivement, à une électrode de connexion, ces deux électrodes de connexion étant isolées électriquement du matériau à effet Hall et formant avec le matériau à effet Hall, respectivement, un condensateur.

5. Gyrateur suivant l'une des revendications 1 à 4,
   **caractérisé en ce que**
   le matériau à effet Hall a, dans au moins deux dimensions de l'espace, une étendue telle qu'il contient, dans chacune de ses dimensions de l'espace, au moins un million d'électrons mobiles dans les deux directions de l'espace.

6. Gyrateur suivant l'une des revendications 1 à 5,
   **caractérisé en ce que**
   le matériau à effet Hall a au moins, dans au moins deux dimensions de l'espace, une étendue d'au moins 100 nm, de préférence d'au moins 500 nm et, d'une manière tout à fait préférée, d'au moins 1 $\mu$m.

7. Gyrateur suivant l'une des revendications 1 à 6,
   **caractérisé en ce que**,
   suivant le pourtour extérieur du matériau à effet Hall, qui va d'une électrode de connexion reliée à la porte d'entrée à une électrode de connexion reliée à la porte de sortie, la capacité locale mesurée par unité de longueur dans les régions de borne des électrodes de connexion est plus petite que dans les autres régions des électrodes de connexion.

8. Gyrateur suivant l'une des revendications 1 à 7,
   **caractérisé en ce que**,
   suivant un pourtour extérieur du matériau à effet Hall, qui va d'une électrode de connexion reliée à la porte d'entrée à une électrode de connexion reliée à la porte de sortie, la capacité locale par unité de longueur du condensateur formé par chaque électrode de connexion avec le matériau à effet Hall est limitée.

9. Gyrateur suivant l'une des revendications 1 à 8,
   **caractérisé en ce qu'**
   il est prévu des moyens d'application, à la région isolée entre au moins une électrode de connexion et le matériau à effet Hall d'un champ électrique de polarisation, qui modifie la répartition dans l'espace de la capacité par la région de l'électrode de connexion.

10. Gyrateur suivant la revendication 9,
    **caractérisé en ce que**
    le condensateur contient un ferroélectrique ou un diélectrique non linéaire comme isolant entre l'électrode de connexion et le matériau à effet Hall.

11. Gyrateur suivant l'une des revendications 1 à 10,
    **caractérisé en ce que**
    **en ce que** les électrodes de connexion sont disposées suivant un pourtour extérieur du matériau à effet Hall les unes par rapport aux autres de manière à ce que, dans des sens opposés suivant ce pourtour, il est parcouru d'une électrode de connexion à l'électrode de connexion voisine, respectivement, des trajets, dont la longueur ne diffère de pas plus de 10%.

12. Gyrateur suivant l'une des revendications 1 à 11,
**caractérisé en ce que**
le matériau à effet Hall a des trous, dont la surface totale représente jusqu'à neuf fois la surface occupée par le matériau à effet Hall.

13. Gyrateur suivant l'une des revendications 1 à 12,
**caractérisé en ce que**
le pourtour extérieur du matériau à effet Hall a, au moins dans une région partielle dans lequel l'une des électrodes de connexion forme avec lui un condensateur, une structure fractale.

14. Gyrateur suivant l'une des revendications 1 à 13,
**caractérisé en ce que**
les condensateurs formés par toutes les électrodes de connexion, respectivement, avec la matériau à effet Hall ont des capacités, qui diffèrent les unes des autres de 10% au plus.

15. Gyrateur suivant l'une des revendications 1 à 14,
**caractérisé en ce que**
le matériau à effet Hall forme avec au moins une électrode de connexion un condensateur suivant au moins un pourtour extérieur sur au moins 2%, de préférence entre 50% à 70%, de la longueur de ce pourtour extérieur.

16. Gyrateur suivant l'une des revendications 1 à 15,
**caractérisé en ce qu'**
au moins une électrode de connexion forme un condensateur avec plusieurs couches, isolées électriquement les unes des autres, du matériau à effet Hall.

17. Gyrateur suivant l'une des revendications 1 à 16,
**caractérisé en ce que**
le matériau à effet Hall est un matériau à effet Hall quantique.

Figur 1

Figur 2

Figur 3

Figur 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2649574 A
- DE 102013006377
- DE 1144355 B
- US 3214682 A1


**In der Beschreibung aufgeführte Nicht-Patentliteratur**

- Generalized four-point characterization method using capacitive and ohmic contacts. **KIM BRIAN S. et al.** Review of Scientific Instruments. AIP, 01. Februar 2012, vol. 83, 24703-24703
- **MACIEJ J OGORZALEK.** *APPLICATIONS OF FRACTALS IN ELECTRONICS,* 20. Juli 2007
- **J. SHEKEL.** *Proceedings of the IRE,* 1953, vol. 41 (8), 1014